# FASCICULE DE BREVET EUROPEEN

(11) **EP 3 330 240 B1**
(45) Date de publication et mention de la délivrance du brevet: **06.07.2022**
(21) Numéro de dépôt: 17204501.5
(22) Date de dépôt: 29.11.2017
(51) Int. Cl.: C04B 41/89, C04B 41/00, C04B 41/52, C30B 11/00, C30B 35/00, C04B 41/50, C04B 35/573, C04B 35/80, C04B 41/87, C30B 29/06, C04B 111/00

(54) **PROCEDE POUR LA SILICIURATION SURFACIQUE DE GRAPHITE**
VERFAHREN ZUR OBERFLÄCHENSILIZIERUNG VON GRAPHIT
METHOD FOR SURFACE SILICIDATION OF GRAPHITE

(30) Priorité: 01.12.2016 FR 1661788
(43) Date de publication de la demande: 06.06.2018
(73) Titulaire: Commissariat à l'Energie Atomique et aux Energies Alternatives, 75015 Paris (FR)
(72) Inventeur: DREVET, Béatrice, 38000 GRENOBLE (FR); CAMEL, Denis, 73000 CHAMBERY (FR); CIERNIAK, Etienne, 71680 CRECHES SUR SAONE (FR); COUSTIER, Fabrice, 73000 CHAMBERY (FR); VEILLY, Maxime, 26790 TULETTE (FR)
(74) Mandataire: Nony

(56) Documents cités:
- WO-A1-2016/087549
- WO-A2-99/05338
- WO-A2-2010/026344
- FR-A5- 2 068 160

## Description

La présente invention concerne un procédé de siliciuration de matériau carboné en graphite, en particulier par voie liquide.

Les cellules photovoltaïques (PV) sont majoritairement fabriquées à partir de silicium mono- ou multi-cristallin, dans des filières qui mettent en jeu la solidification de lingots à partir d'un bain liquide contenu dans un creuset à section carrée. Les lingots de silicium multi-cristallin sont classiquement réalisés par fusion d'une charge de silicium suivie d'une solidification directionnelle. Ce procédé est très efficace pour cristalliser de grands volumes de silicium et la taille des lingots est extensible par extension de la dimension des creusets. Un revêtement anti-adhérent poreux à base d'une poudre de nitrure de silicium est déposé systématiquement sur les parois internes du creuset pour assurer le démoulage du lingot final une fois solidifié (US 00 6165425). Dans l'industrie photovoltaïque, les creusets sont en silice frittée. Ils sont à usage unique compte tenu de la déformation de la silice à haute température et de sa recristallisation au cours du cycle thermique.

Dans un souci de diminution des coûts de fabrication, il serait avantageux de disposer de creusets en matériaux réfractaires réutilisables, présentant une bonne tenue mécanique à haute température et dont la formulation chimique ne contient pas d'éléments métalliques susceptibles de contaminer le silicium et de dégrader ses performances photovoltaïques.

Parmi ces matériaux réfractaires, le graphite s'avère être un bon candidat compte tenu de son coût de fabrication modéré et du fait qu'il soit facilement usinable. Certaines nuances de graphite (par exemple celle de grade 2020 de MERSEN) peuvent présenter un coefficient de dilatation relativement adapté à celui du silicium de telle façon que le creuset peut être constitué d'une seule pièce (creuset monolithique). Le cas échéant, ou pour des creusets de très grandes dimensions, le creuset peut être réalisé à partir de plaques constituant le fond et les parois latérales et assemblées entre elles de façon mécanique comme dans le document WO/2016/087549.

Toutefois, il a été constaté que dans de tels creusets, recouverts des revêtements anti-adhérents constitués d'une poudre de nitrure de silicium, qui sont conventionnellement utilisés pour éviter le collage du silicium, des réactions chimiques se produisent à haute température entre le silicium, la silice contenue dans le nitrure de silicium et le graphite et sont à l'origine d'une production de monoxyde de carbone (CO). L'espèce gazeuse CO réagit alors avec le silicium en fusion pour former une couche de carbure de silicium (SiC) encapsulant le bain et saturer le silicium en carbone (la concentration en carbone correspondant à la composition eutectique du diagramme de phases Si-C). Lors de la solidification, le carbone précipite sous forme de SiC. Or, ces précipités de SiC sont néfastes à plusieurs titres. Ils sont préjudiciables à la découpe des lingots en raison de leur dureté. D'un point de vue électrique, ils peuvent créer des court-circuits parasites dans les cellules solaires correspondantes.

Des revêtements anti-adhérents mieux adaptés à des creusets à base de carbone pour la solidification du silicium ont donc été proposés.

Ainsi, dans les demandes de brevet GB2479165A, WO2011/120598A1, le creuset est un composite C-C/SiC et le revêtement est constitué d'un mélange de poudres de Si et de Si₃N₄. Le creuset et son revêtement subissent un traitement thermique à une température supérieure à 1200°C sous azote. Au contact de la surface du creuset, le silicium réagit avec le carbone pour former du SiC à l'interface. Au contact de l'azote, ce silicium se transforme en revanche en Si₃N₄ (si le revêtement est épais, il reste du Si libre). La formation de SiC en contact des faces en graphite du creuset garantit une liaison forte entre le revêtement et le creuset. Le revêtement final SiC/Si/Si₃N₄ est résistant au frottement et peut être réutilisable. Toutefois, la formation de nitrure de silicium à la surface des particules par réaction avec l'atmosphère d'azote empêche que le silicium fondu s'étale en une couche liquide continue à la surface du graphite. Il s'ensuit que le SiC, formé par réaction avec le carbone, ne constitue pas une couche imperméable, ce qui est une source de contamination du silicium en carbone. De plus, la réaction du silicium avec l'azote et le carbone risque d'être incomplète, selon la taille des particules et l'épaisseur du revêtement. Cette réaction incomplète peut conduire à la présence de résidus de silicium libre dans le revêtement final, et donc nuire à la stabilité de la microstructure du revêtement lors d'utilisations successives. Ces mêmes inconvénients sont observés pour les revêtements décrits dans les documents JP2005046866 et JP4081413 et qui consistent en un revêtement en deux couches, une couche formée d'un mélange de poudres de Si, Si₃N₄ et SiO₂ côté creuset, et une couche de surface formée d'un mélange de poudres de Si₃N₄ et SiO₂.

Le document WO 99/05338 A2 décrit la conversion en carbure de silicium des régions de composants en graphite les plus sensibles à l'érosion dans un appareil Czochralski, formant ainsi un revêtement protecteur.

Le document FR 2 068 160 A5 concerne un procédé de fabrication de corps composites graphite-pyrocarbone-carbure de silicium ou carbure à base de silicium par immersion d'un corps carboné dans un bain de silicium ou à base de silicium, et par mise en contact du corps ainsi imprégné avec une pièce en graphite très poreux pour éliminer le silicium libre excédentaire.

La présente invention a donc pour objet de proposer un nouveau revêtement dénué des insuffisances précitées à savoir une susceptibilité à la contamination et un défaut de stabilité prolongé dans le temps.

Plus généralement, la présente invention vise à proposer un procédé permettant d'élaborer en surface d'un matériau carboné, à l'image en particulier du graphite, carbone vitreux ou graphite recouvert d'une couche de carbone pyrolytique, une couche de SiC imperméable, dénuée de silicium résiduel et présentant une bonne adhérence au substrat considéré.

Plus particulièrement, la présente invention vise à proposer un procédé permettant d'élaborer en surface d'un matériau graphite conventionnel, c'est-à-dire généralement doté d'une porosité inférieure à 25 % et d'un diamètre de pores inférieur à 2 µm, une couche de SiC imperméable, dénuée de silicium résiduel et présentant une bonne adhérence sur le graphite.

La présente invention vise notamment à proposer un procédé utile pour la siliciuration surfacique d'un matériau carboné, notamment choisi parmi le graphite, le carbone vitreux et le carbone pyrolytique, comprenant au moins les étapes consistant à :
a) mettre en contact ladite surface à traiter avec une quantité efficace de particules de silicium de taille granulométrique variant de 0,2 à 500 µm, de pureté entre 2N et 5N, et dont la teneur en oxygène est inférieure à 10 % en poids.
b) imposer au moins à ladite surface revêtue desdites particules de silicium un traitement thermique propice à la fusion du silicium et à son interaction à l'état fondu avec le carbone de ladite surface pour former du SiC en quantité suffisante pour former, en surface, une couche superficielle de SiC imperméable et en contact direct avec le carbone de ladite surface externe et combler, si existantes, les porosités de ladite surface et
c) éliminer le silicium libre en excès notamment par évaporation sous vide,
les étapes b) et c) étant réalisées au moyen d'un traitement thermique comprenant au moins un cycle de 3 étapes successives correspondant à une montée en température, notamment à une vitesse comprise entre 300 et 600°C/h, jusqu'à une température propice à la fusion dudit silicium, notamment supérieure à 1415°C, le maintien d'un palier de température, notamment d'au moins 20 minutes, à ladite température propice à la fusion du silicium et un refroidissement en température notamment à une vitesse comprise entre 100 et 600°C/h.

Ainsi, l'invention concerne un procédé utile pour la siliciuration surfacique d'un matériau carboné selon la revendication 1.

Selon une variante de réalisation, la siliciuration peut être réalisée comme suit :
- Réalisation d'un ou plusieurs cycles thermiques pour former la couche imperméable de SiC. A l'issue de cette étape, il est possible de contrôler visuellement la présence de silicium résiduel sur toute la surface de la pièce devant recevoir une couche de SiC et
- Réalisation d'un deuxième cycle thermique pour évaporer le silicium en excès.

Selon l'invention, le matériau carboné est un substrat en graphite et possédant, au moins au niveau de la surface à siliciurer, une porosité volumique inférieure à 25% et un diamètre de pores inférieur à 2 µm.

Ainsi, le procédé de l'invention comprend au moins les étapes consistant à :
i) disposer d'un substrat en graphite possédant, au moins au niveau de la surface à siliciurer, une porosité volumique inférieure à 25 % et un diamètre de pores inférieur à 2 µm.
   a) mettre en contact ladite surface à traiter avec une quantité efficace de particules de silicium de taille granulométrique variant de 0,2 à 500 µm, de pureté entre 2N et 5N, et dont la teneur en oxygène est inférieure à 10 % en poids,
   b') imposer au moins à ladite surface revêtue desdites particules de silicium un traitement thermique propice à la fusion du silicium et à son interaction à l'état fondu avec le graphite de ladite surface pour former du SiC en quantité suffisante pour combler les porosités de ladite surface et former, en surface, une couche superficielle de SiC imperméable et en contact direct avec du graphite de ladite surface externe dudit substrat, et
   c) éliminer le silicium libre en excès par évaporation sous vide,
   les étapes b') et c) étant réalisées au moyen d'un traitement thermique comprenant au moins un cycle de 3 étapes successives correspondant à une montée en température, notamment à une vitesse comprise entre 300 et 600°C/h, jusqu'à une température propice à la fusion dudit silicium, notamment supérieure à 1415°C, le maintien d'un palier de température, notamment d'au moins 20 minutes, à ladite température propice à la fusion du silicium et un refroidissement en température notamment à une vitesse comprise entre 100 et 600°C/h.

Le procédé de l'invention peut avantageusement comprendre en outre à l'issue de l'étape d'élimination de l'excès de silicium, une étape dédiée à la formation en surface de la couche continue et adhérente de carbure de silicium obtenue selon l'invention, d'un revêtement anti-adhérent poreux de nitrure de silicium.

La formation d'un tel revêtement de nitrure de silicium relève clairement des compétences de l'homme de l'art.

Au sens de l'invention, l'expression « en contact direct » signifie que la couche superficielle de SiC est au moins en partie directement en contact avec du graphite constitutif du substrat traitée selon l'invention.

Dans le cas d'un comblement conjoint de porosités par du SiC, le SiC de la couche superficielle et le SiC des porosités sont continus, ce qui renforce l'adhérence de la couche superficielle sur le matériau carboné, en l'occurrence le graphite. En conséquence, la couche superficielle de SiC obtenue selon l'invention, peut être également caractérisée comme possédant, avec le graphite constituant le substrat, une interface qui est formée du SiC comblant les pores et de graphite constitutif du substrat, la fraction volumique de SiC étant inférieure à celle du graphite dans cette interface.

Selon une variante de réalisation particulière, les particules de silicium sont mises en œuvre dans l'étape a) sous la forme d'une dispersion dans un milieu solvant, notamment aqueux.

Selon une autre variante de réalisation, la mise en contact de la surface à traiter avec une quantité efficace de particules de silicium est réalisée en présence d'un liant polymérique notamment réticulable et par exemple l'alcool polyvinylique (PVA), ce liant constituant de préférence une partie du milieu solvant.

Dans cette variante, le procédé comprend, préalablement à l'étape b) une étape visant à amorcer la réticulation de ce polymère. Pour ce faire, il est avantageux de chauffer directement la surface du substrat carboné et notamment de graphite en contact avec le liant polymérique réticulable.

Ainsi selon une variante de réalisation, le procédé selon l'invention comprend préalablement à l'étape b) au moins les étapes consistant à
- disposer d'une dispersion en milieu solvant de particules de silicium selon l'invention et comprenant en outre un liant polymérique réticulable et
- mettre en contact ladite dispersion avec la surface à traiter dudit substrat carboné, de préférence en graphite, ladite surface étant chauffée à une température propice à l'initiation de la réticulation dudit liant.

Ce mode de réalisation particulier a pour avantage de consolider efficacement le dépôt des particules de silicium au niveau de la surface avant la siliciuration.

Selon un mode de réalisation préféré, la couche superficielle de SiC formée selon l'invention possède une épaisseur variant de 2 à 15 µm.

La couche superficielle de SiC est constituée à plus de 99% en poids de préférence à plus de 99,9 % voire à plus de 99,99% en poids de SiC.

Ainsi, les inventeurs ont constaté que sous réserve de sélectionner une charge ajustée en poudre de silicium, par ailleurs dotée d'une granulométrie particulière et un traitement thermique spécifique, il s'avère possible d'assurer en une unique opération une siliciuration efficace d'un substrat carboné et en particulier en graphite, conduisant à une couche imperméable de SiC, fortement adhérente au graphite, et exempte de silicium résiduel.

Certes, la siliciuration du graphite est connue de l'homme de l'art. Ces procédés de siliciuration conventionnels sont réalisés par voie gazeuse ou par voie liquide. Toutefois, ils sont pour l'essentiel uniquement dédiés à conférer, au graphite considéré, une résistance à l'oxydation sous air à haute température (supérieure à 500°C typiquement).

Parmi les procédés par voie gazeuse, on trouve la technique de dépôt CVD (Chemical Vapor Déposition) permettant de déposer des couches épaisses de SiC (de l'ordre de 100 µm). Un tel graphite siliciuré est par exemple commercialisé par la société TOYOTANSO sous la marque PERMA KOTE^{®}. Cependant, la couche de SiC CVD présente peu d'adhérence sur le graphite car le dépôt ne pénètre pas dans la porosité du matériau, ce qui confère une certaine fragilité aux pièces revêtues. Par ailleurs, le procédé CVD n'est applicable qu'aux graphites présentant un coefficient de dilation supérieur à celui du SiC, et de fait bien supérieur à celui du silicium. Ces graphites ne peuvent donc pas être utilisés en tant que matériaux de creuset pour le silicium. D'autre part, un inconvénient du procédé CVD est son coût très élevé.

Parmi les procédés par voie gazeuse, on trouve également le procédé RGI (Reactive Gaseous Infiltration) mettant enjeu l'espèce gazeuse SiO. Ce procédé a été utilisé par la société MERSEN et permet de former une couche de surface de SiC d'une épaisseur comprise entre 20 et 100 µm [Israel et al., J. Eur. Ceram. Soc. 31 (2011) 2167]*.* A titre d'exemples, on peut citer les brevets JP05146843 et JP06000578 dans lesquels des mélanges de poudres (SiC + SiO₂) ou (C + SiO₂) sont utilisés pour générer l'espèce SiO. Ces procédés de dépôt par voie gazeuse sont longs et coûteux. D'autre part, ils peuvent s'avérer difficiles de mise en œuvre en termes de circulation des gaz réactifs et d'homogénéité du dépôt pour des géométries de pièces telles que des creusets.

Pour ce qui est de la siliciuration du graphite par voie liquide par réaction entre le graphite et le silicium liquide, une des méthodes connues consiste à immerger la pièce de graphite dans un bain de silicium liquide [Chunhe et al., J. Nucl. Mater. 224 (1995) 103]*.* Pour des raisons évidentes, elle est difficilement applicable à des pièces de grandes dimensions telles que les creusets de cristallisation du silicium PV. Pour sa part, le document WO 2010/026344 met en contact une surface en graphite d'un substrat considéré avec du silicium liquide (sans plus de précision sur la manière de réaliser ce contact) pour former une couche de surface en SiC et une couche intermédiaire intercalée entre la couche de surface en SiC et le support en graphite, ladite couche intermédiaire étant formée d'une matrice de SiC contenant au moins un nodule de carbone. Pour obtenir de telles caractéristiques de la couche intermédiaire, le graphite doit posséder une porosité volumique élevée, variant de 25 à 40 %, préférentiellement de 30 à 35%, et s'étendant sur une épaisseur d'au moins 1 mm. Ces dernières caractéristiques ont l'inconvénient de s'écarter de celles des graphites conventionnels élaborés en pièces de grandes dimensions.

Le procédé selon l'invention est clairement différent de ces technologies antérieures et s'avère par ailleurs significativement plus intéressant à plusieurs titres.

Il est significativement simplifié en termes de mise en œuvre. Il est de coût amoindri notamment par rapport à des procédés tels que le dépôt CVD. Il peut être réalisé sur des objets de taille importante et de forme complexe. Enfin, il permet la réalisation d'une couche de SiC imperméable et dénuée de silicium résiduel, et de conduire à une bonne adhérence du SiC sur du graphite grâce à l'infiltration du silicium dans la porosité du substrat graphite.

Il est ainsi tout particulièrement intéressant pour siliciurer des creusets en graphite dédiés à un usage pour la fonte et la solidification de silicium.

Le procédé selon l'invention est également utile pour protéger les pièces en graphite utilisées dans la zone chaude des dispositifs de solidification dirigée en creuset et de tirage Czochraski, telles que les contre-creusets, les couvercles de creuset, les résistors, les boucliers thermiques, etc. Ces pièces subissent une corrosion par les vapeurs de SiO dégagées par le bain de silicium, ce qui les dégradent et nécessite de les renouveler. Par ailleurs, la réaction entre C et SiO génère du CO qui pollue le silicium en carbone.

La présente description décrit également un substrat carboné et de préférence en graphite dont au moins une des surfaces externes est siliciurée avec le procédé selon l'invention.

Selon un autre de ses aspects, la présente description décrit un substrat en graphite dont au moins une des surfaces externes est revêtue d'une couche superficielle et imperméable de SiC, ladite couche externe de SiC étant constituée à plus de 99 % en poids de SiC, possédant une épaisseur moyenne de 2 à 15 µm, et une interface, avec le graphite constituant ledit substrat, qui est formée de SiC comblant des pores du graphite constitutif du substrat, avec une fraction volumique de SiC inférieure à celle du graphite dans cette interface.

Selon une variante préférée, ce substrat est un creuset de graphite dédié à un usage pour la fonte et la solidification de silicium et dont la surface externe de sa cavité intérieure est revêtue en surface d'une couche superficielle de SiC.

Selon une variante préférée, ce creuset possède en surface externe de la couche de SiC formée selon le procédé de l'invention, un revêtement anti-adhérent en nitrure de silicium. La présence de ce revêtement anti-adhérent en nitrure de silicium est avantageuse lors de la mise en œuvre du creuset. Il est destiné à être en contact avec le silicium liquide lors de la cristallisation du silicium, et ce afin d'éviter que le silicium reste accroché au creuset.

### I- PROCEDE SELON L'INVENTION

Comme énoncé ci-dessus, le procédé selon l'invention met en contact un substrat carboné avec des particules de silicium.

### a) Substrat carboné

Comme exposé précédemment, le procédé selon l'invention convient à la siliciuration de matériaux carbonés de graphite.

Le graphite constitutif de la surface du substrat à traiter possède une certaine porosité ouverte.

Dans le cadre du procédé de l'invention, cette porosité doit posséder une taille compatible avec une infiltration de silicium fondu. Ce phénomène d'infiltration contribue à renforcer significativement l'adhérence de la couche surperficielle de SiC formée par ailleurs en surface de la zone traitée. Cette porosité doit par ailleurs rester suffisamment faible pour éviter la formation, entre le graphite du substrat et la couche superficielle de SiC, d'une couche intermédiaire formée de SiC et de nodules de carbone.

Ainsi, le graphite constitutif de la surface du substrat de graphite à traiter et généralement le graphite constitutif du substrat à traiter possèdent à la fois une porosité volumique inférieure à 25% et un diamètre de pores inférieur à 2 µm.

Selon une variante de réalisation préférée, le graphite constitutif de la surface du substrat de graphite à traiter et généralement le graphite constitutif du substrat à traiter possèdent une porosité volumique inférieure à 20%.

Ces deux quantités peuvent être évaluées par porosimétrie mercure.

L'invention s'avère tout particulièrement intéressante pour la siliciuration surfacique de substrats en graphite isostatique à grains fins présentant une taille de grains inférieure à 30 µm.

Selon une variante de réalisation préférée, ce substrat est un creuset dont la surface traitée est sa cavité interne.

Le procédé selon l'invention requiert le dépôt en surface de la zone de substrat à traiter d'une quantité de silicium.

### b) Particules de silicium

Les particules de silicium, considérées selon le procédé de l'invention sont destinées à être fondues pour former une couche superficielle de SiC.

La couche de SiC formée selon l'invention est constituée pour l'essentiel de SiC voire exclusivement de SiC.

Cette couche de SiC est en outre avantageusement solidaire des infiltrations de silicium dans les pores d'origine du matériau carboné si existantes comme dans le cas du graphite, et de ce fait possède une adhérence renforcée avec le substrat.

Ces résultats tout particulièrement intéressants sont notamment obtenus via les spécificités considérées pour les particules de silicium utilisées selon l'invention et leur quantité mise en œuvre pour la réalisation du procédé de l'invention.

Ainsi, le silicium considéré selon l'invention se présente sous la forme d'une poudre de silicium possédant avantageusement un diamètre moyen (en volume) variant de 0,2 à 500 µm de préférence de 1 à 50 µm.

Cette granulométrie peut notamment être caractérisée en utilisant un granulomètre à diffraction laser.

Il possède en outre une pureté entre 2N et 5N et une teneur en oxygène inférieure à 10% en poids. Celle-ci peut être mesurée en fondant la poudre de silicium dans un creuset en graphite sous gaz inerte et en mesurant par un détecteur infra-rouge le CO libéré et transformé en CO₂.

Selon une variante de l'invention, il s'agit d'une poudre de silicium de recyclage issue de la découpe des lingots de silicium à la scie à fil diamant avec un lubrifiant constitué d'eau et d'additifs organiques (tels que des surfactants et des anti-oxydants par exemple). La poudre mélangée à l'eau et aux additifs organiques est récupérée dans des bacs directement reliés aux machines de découpe. Une étape de séchage est effectuée pour évaporer l'eau et une partie des additifs organiques. La poudre de silicium recyclée a une pureté comprise entre 2N et 4N et présente une teneur en oxygène inférieure à 10 % en poids.

La quantité de silicium mise en œuvre en étape a) est ajustée pour permettre un comblement des pores si existants au niveau de la surface à traiter et la formation d'une couche superficielle de SiC en surface notamment d'épaisseur de l'ordre de 2 à 15 µm.

La détermination de cette quantité est clairement à la portée de l'homme du métier.

Ainsi, la quantité en SiC devant être infiltrée peut être facilement évaluée par l'homme de l'art, connaissant la porosité ouverte du graphite et la profondeur de silicium à infiltrer. Par exemple, dans le cas de la nuance de graphite 2020 de MERSEN, la porosité ouverte est de 11% et la profondeur infiltrable est de l'ordre de 1 mm.

Avantageusement, la quantité de silicium à déposer par unité de surface du graphite correspond à la quantité de silicium à infiltrer dans la porosité si existante du matériau carboné et transformée en SiC, majorée d'un excès de silicium, de l'ordre de 10 à 20 mg/cm². Cet excès est avantageux pour assurer la formation d'une couche superficielle imperméable de SiC sans toutefois conduire à des excès de silicium à évaporer trop importants.

L'étape d'évaporation de l'excès de silicium peut avantageusement être réalisée par reproduction d'un cycle thermique sous vide.

Comme évoqué précédemment, cette poudre de silicium peut être mise en œuvre en dispersion dans un milieu solvant généralement aqueux. Cette dispersion de silicium peut posséder avantageusement une concentration d'au moins 10 % en poids de silicium.

Selon une autre variante de réalisation, la poudre de silicium peut être mise en œuvre conjointement à au moins un liant polymérique réticulable.

En particulier, dans le cas d'espèce où la poudre de silicium est mise en œuvre en dispersion dans un milieu solvant, il est envisageable que ce liant polymérique constitue une partie de ce milieu solvant.

En effet, les inventeurs ont ainsi noté que la présence d'un tel liant s'avère particulièrement intéressante pour consolider le dépôt des particules de silicium avant le traitement thermique de siliciuration.

Selon cette variante de réalisation, il est réalisé, préalablement au traitement thermique dédié à promouvoir la siliciuration surfacique, un pré-traitement propice à l'initiation de la réticulation du liant polymérique. De préférence, il s'agit d'un traitement thermique.

Ce traitement peut notamment consister en un chauffage de la surface à traiter dudit substrat carboné et de préférence en graphite, et sur laquelle est déposé le mélange contenant la poudre de silicium, l'eau et le liant polymérique à réticuler, à une température propice à l'initiation de cette réticulation, de préférence à une température variant de 150°C à 300°C.

L'ajustement de cette température est bien entendu fonction de la nature du liant polymérique et relève clairement des compétences de l'homme de l'art.

A titre représentatif et non limitatif des liants polymériques convenant au procédé selon l'invention peuvent notamment être cités les alcools polyvinyliques (PVA).

Par exemple, l'alcool polyvinylique (PVA) peut être dissous dans de l'eau dans un rapport massique 1 à 10 PVA: 100 H₂O.

Un tel alcool polyvinylique (PVA) est de préférence mis en œuvre dans un rapport massique [Si: PVA] variant de [1 Si: 0,2 PVA] à [1 Si : 0,02 PVA], et de préférence de [1 Si : 0,15 PVA] à [1 Si : 0,04 PVA].

L'utilisation conjointe aux particules de silicium d'un liant polymérique réticulable est particulièrement intéressante dans la mesure où le liant permet, sous sa forme réticulée, de consolider le dépôt des particules de silicium en surface du substrat carboné et notamment de graphite avant le traitement thermique de siliciuration. La manipulation des substrats et notamment leur chargement dans le four de traitement thermique s'en trouvent en outre facilités.

Le traitement thermique consécutif, dédié à réaliser la siliciuration a d'ailleurs pour effet d'éliminer tous les composés organiques et donc toute trace de ce liant réticulé. La couche superficielle de SiC formée à l'issue de cette variante de réalisation de procédé ne possède donc avantageusement plus de trace de ce polymère réticulé.

Selon une variante de réalisation, les particules de silicium peuvent en outre être mises en œuvre en association avec un matériau réfractaire M pulvérulent annexe. Bien entendu ce matériau doit être non polluant vis-à-vis du silicium. Il s'agit donc avantageusement de carbure de silicium, de nitrure de silicium, de carbone ou d'un de leurs mélanges. La granulométrie de la poudre de matériau réfractaire M est généralement comprise entre 0,1 et 20 µm, préférentiellement entre 1 et 5 µm. En particulier, les rapports massiques [Si: M] peuvent être compris entre [1 Si: 0,7 M] et [1 Si: 0,1 M], préférentiellement entre [1 Si: 0,5 M] et [1 Si: 0,3 M]. A l'issue du traitement de siliciuration, les particules de matériau réfractaire se retrouvent au-dessus de la couche superficielle de SiC, et si le matériau réfractaire est du carbone au départ, il est transformé en SiC par réaction avec le silicium liquide en excès.

### c) Cycle thermique pour la siliciuration

Comme énoncé précédemment, la couche de SiC formée selon l'invention est constituée exclusivement de SiC, possède une faible épaisseur, est avantageusement imperméable et manifeste une adhérence renforcée avec le substrat carboné et notamment de graphite.

Ces propriétés sont également conditionnées par le cycle thermique requis selon l'invention.

Avantageusement, ce cycle thermique n'est pas réalisé sous atmosphère azotée.

Comme il ressort de ce qui suit le traitement thermique comprend avantageusement au moins un cycle réalisé sous vide et de préférence sous une pression inférieure à 0,1 Pa.

Ce cycle peut être unique.

Ce cycle peut également être combiné à un ou plusieurs cycles annexes réalisés en revanche sous atmosphère neutre mais non azotée.

Dans le cas où le cycle est unique, au moins l'étape d'évaporation du silicium en excès est faite sous vide, et l'étape de formation de la couche continue de SiC peut être faite sous atmosphère neutre, en particulier non azotée.

Un cycle thermique comprend au moins
- une montée en température jusqu'à une température propice à la fusion dudit silicium,
- le maintien d'un palier de température à cette température adaptée à la fusion du silicium et
- un refroidissement en température.

Selon une variante préférée, la montée en température est réalisée à une vitesse variant de 300 à 600°C/h jusqu'à atteindre la température retenue comme étant propice à la fusion du silicium. La vitesse de montée est variable selon les dimensions des pièces de graphite et est adaptée pour obtenir un chauffage homogène des pièces. Par exemple, une montée à 300°C/h convient à des pièces de dimensions 36x26x2 cm³, et une montée à 600°C/h convient à des pièces de dimensions 5x5x0,5 cm³.

Avantageusement, la température propice à la fusion dudit silicium est supérieure à 1415°C et notamment varie de 1430°C à 1500°C. Il s'agit donc de la température à laquelle le palier de température est maintenu. Le maintien de cette température est réalisé le temps nécessaire à la formation de la couche continue de SiC au contact du graphite et du silicium liquide (qui est de l'ordre de 20 minutes) et à l'évaporation du silicium en excès (de 6 à 15 heures selon la quantité de silicium à évaporer).

Le refroidissement en température est ensuite réalisé à une vitesse variant de 100 à 600°C/h pour limiter les contraintes thermomécaniques, le cas échéant sous atmosphère inerte.

Il est généralement réalisé sous rampe jusqu'à une température variant de 500 à 700°C et ensuite poursuivi naturellement jusqu'à température ambiante.

Selon un mode de réalisation préféré, un cycle thermique conforme à l'invention comprend
- une montée en température à une vitesse variant de 300 à 600°C/h jusqu'à une température supérieure à 1415°C,
- un maintien à cette température pendant une durée de 20 min à 15 h,
- un refroidissement en température à une vitesse variant de 100 à 600°C/h sous atmosphère inerte jusqu'à une température de 500 à 700°C, et un refroidissement naturel jusqu'à la température ambiante.

Il est à noter que le traitement thermique selon l'invention peut requérir un unique cycle tel que décrit ci-dessus ou plusieurs cycles.

Ainsi, dans une variante du procédé, la siliciuration peut être réalisée comme suit :
- Réalisation d'un ou plusieurs cycles thermiques sous gaz ou sous vide pour former la couche imperméable de SiC. A l'issue de cette étape, il est possible de contrôler visuellement la présence de silicium résiduel sur toute la surface de la pièce devant recevoir une couche de SiC et
- Réalisation d'un deuxième cycle thermique sous vide pour évaporer le silicium en excès.

Ce mode de réalisation en plusieurs cycles sera avantageux pour mettre au point les paramètres permettant de traiter des pièces en un cycle unique, dans une configuration donnée et dans un four donné.

### d) Couche superficielle de SiC selon l'invention

Au sens de l'invention, l'expression « constituée exclusivement de SiC » entend signifier que la couche superficielle de SiC est constituée à plus de 99% en poids de préférence à plus de 99,9 % voire à plus de 99,99% en poids de SiC. La pureté de la couche de SiC peut être caractérisée par spectrométrie de masse à décharge luminescente.

La valeur moyenne de l'épaisseur de la couche superficielle de SiC varie avantageusement de 2 à 15 µm.

L'épaisseur de la couche superficielle de SiC peut être mesurée par les techniques classiques de caractérisation (microscopie optique, microscopie électronique à balayage) sur des coupes transverses.

Comme précisé ci-dessus, la couche superficielle de SiC est imperméable aux gaz et notamment à l'air.

Cette spécificité peut également être caractérisée. Il est connu que le SiC présente, contrairement au graphite, une tenue sous air importante, jusqu'à une température sensiblement égale à 1550°C. En conséquence, une manière de savoir si la couche superficielle formée est imperméable à l'air, est de soumettre la pièce en graphite recouverte de SiC à un traitement d'oxydation sous air.

Ainsi, une couche est considérée comme conforme en termes d'imperméabilité aux exigences de l'invention, et elle sera alors dite « imperméable », si sa perte de poids est inférieure à 10⁻² g/cm² de surface recouverte, préférentiellement inférieure à 3×10⁻³ g/cm² de surface recouverte après un traitement thermique de 2 heures à 900°C sous air et encore plus préférentiellement inférieure à 10⁻³ g/cm² de surface recouverte après un traitement thermique de 4 heures à 1100°C sous air.

Pour une couche superficielle non conforme à cette exigence, du graphite est brûlé en trop grande quantité lors d'un tel traitement thermique et ceci se traduit à terme par la perte d'adhérence de la couche de SiC.

### II- SUBSTRATS CARBONES SILICIURES SELON L'INVENTION

Les substrats carbonés siliciurés obtenus selon l'invention sont avantageusement des creusets de graphite dont la surface externe de leur cavité intérieure est revêtue en surface de ladite couche superficielle de SiC.

Comme précisé précédemment, la surface siliciurée de ces creusets est avantageusement elle-même recouverte en surface par un revêtement anti-adhérent à base de poudre de nitrure de silicium. Ces creusets sont dédiés à un usage pour la fonte et la solidification dirigée de silicium. Ce procédé de solidification dirigée est utilisé pour cristalliser des lingots de silicium photovoltaïque ou encore pour une opération de ségrégation du silicium de grade métallurgique.

Il peut également s'agir de pièces en graphite dédiées à un usage dans un four de cristallisation de silicium.

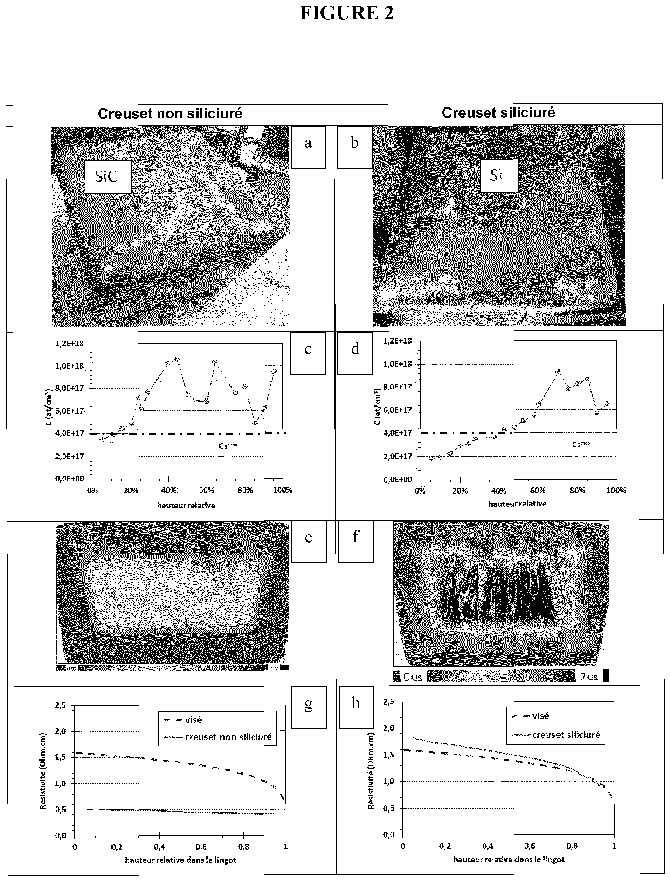

La couche superficielle de SiC formée sur la surface interne du creuset en graphite présente le grand intérêt de permettre d'éviter de carburer le silicium et de le saturer en carbone, et ainsi d'améliorer la qualité du silicium pour les applications en photovoltaïque, PV. Elle joue en outre efficacement un rôle de barrière de diffusion vis-à-vis des impuretés contenues dans le graphite, ce qui permet de fabriquer des lingots de silicium plus purs, présentant ainsi de meilleures propriétés PV. En effet, comme il ressort des exemples ci-après, et plus particulièrement de l'examen des cartographies présentées en figures 2.e et 2.f, la durée de vie maximale des porteurs de charge au cœur du lingot est bien plus élevée pour le lingot élaboré dans le creuset siliciuré (7 µs contre 3 µs). La siliciuration permet donc également d'entraîner une réduction de la contamination en impuretés métalliques.

Pour ce qui est des pièces en graphite des fours de cristallisation, la couche superficielle de SiC formée selon l'invention permet de les protéger de la corrosion par les vapeurs de SiO et de réduire la génération de CO.

Les exemples et figures qui suivent sont présentés à titre illustratif et non limitatif du domaine de l'invention.
Figure 1 : Vue en coupe du graphite siliciuré formé en exemple 1. a) Détail de la couche superficielle de SiC. b) Vue de la couche intermédiaire graphite/SiC.
Figure 2 : Caractéristiques des lingots de silicium PV élaborés dans des creusets en graphite non siliciuré et siliciuré (exemple 2). a) et b) : Vues de la surface libre des lingots. c) et d) Profil des teneurs en carbone dissous le long de la hauteur des lingots. e) et f) Cartographies de durée de vie des porteurs de charge. g) et h) Profil de résistivité visé par le contrôle du dopage de la charge de silicium (pointillés) et profil de résistivité mesuré dans le lingot (traits pleins).
Figure 3 : Vue en coupe de la plaque en graphite siliciurée (exemple 3).

### EXEMPLE 1

### Siliciuration d'un creuset de graphite selon le procédé de l'invention

La siliciuration d'un creuset monobloc en graphite (nuance 2020 de MERSEN de pureté standard) de dimensions intérieures 18x18x18 cm³ est effectuée selon le protocole suivant.

111 g de poudre de silicium de granulométrie de 40 µm et 6 g de PVA sont mélangés à 800 ml d'eau.

Cette dispersion est déposée au pistolet à air comprimé sur les parois internes du creuset chauffé à une température de 200°C à raison de 52 mg de silicium /cm² de surface traitée.

Le creuset ainsi traité subit un cycle thermique dans un four sous vide (pression résiduelle de 0,1 Pa) comme suit
- une montée en température jusqu'à 1450°C avec une rampe de chauffage de 300°C/h,
- un maintien du creuset à cette température de 1450°C pendant 10 h,
- un refroidissement avec une rampe de 300°C/h jusqu'à 1100°C, et un refroidissement naturel jusqu'à la température ambiante.

Le creuset ainsi traité possède en surface de sa cavité interne une couche superficielle de SiC dont l'épaisseur moyenne est environ 6 µm (Fig. la).

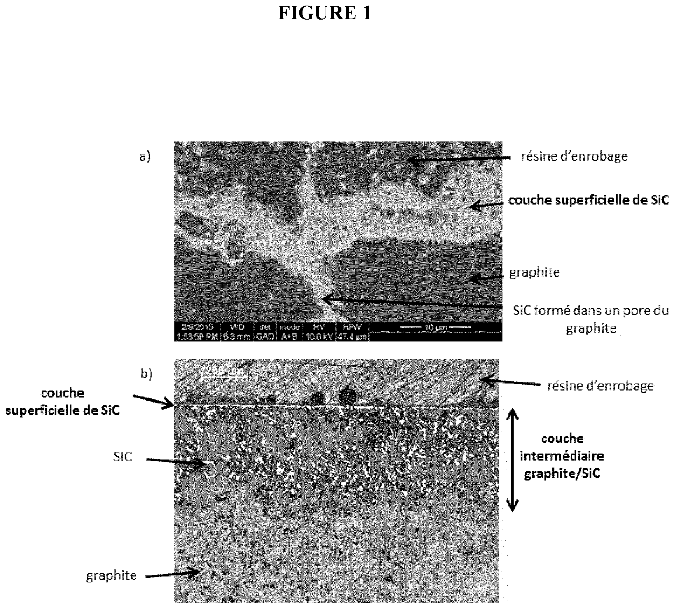

Sous la couche superficielle existe une couche intermédiaire constituée de graphite et de SiC (Fig. 1b). Cette couche intermédiaire traduit l'infiltration du silicium liquide dans la porosité ouverte du graphite et à sa transformation en SiC. Il peut être noté que la fraction volumique de SiC est inférieure à celle du graphite. Cette couche intermédiaire est donc différente de celle du brevet WO 2010/026344 qui est formée d'une matrice de SiC contenant au moins un nodule de carbone.

### EXEMPLE 2

### Utilisation d'un creuset de graphite siliciuré selon le procédé de l'invention pour la fonte d'un lingot de silicium en comparaison d'un creuset mon siliciuré

Deux lingots de silicium multi-cristallin de 10 kg sont cristallisés dans des creusets monoblocs en graphite (nuance 2020 de MERSEN de pureté standard) de dimensions intérieures 18x18x18 cm³, respectivement non siliciuré et siliciuré selon l'exemple 1, sur les parois internes. Ces parois internes sont en outre recouvertes d'un revêtement anti-adhérent à base de poudre de nitrure de silicium permettant le démoulage des lingots.

Dans chaque cas, le creuset a été chargé avec du silicium de qualité électronique dopé à 0,08 ppm en poids de bore, et un cycle thermique de cristallisation identique a été appliqué.

Le four de cristallisation utilisé comprend deux éléments chauffants résistifs situés au-dessus et au-dessous du creuset. Le cycle thermique comprend une montée en température à 85°C/h, suivie d'un palier de fusion de 2 h durant lequel les températures des résistors du bas et du haut sont de 1460°C et 1490°C respectivement. La solidification dirigée est ensuite réalisée en ajustant les rampes de descente en température des deux résistors de façon à ce que la vitesse du front solide/liquide, contrôlée par palpage de ce front à l'aide d'une canne de quartz, reste voisine de 2 cm/h. A l'issue de l'étape de solidification, un palier de 1 h à 1300°C est réalisé, suivi d'un refroidissement de 100°C/h jusqu'à 600°C puis d'un refroidissement naturel jusqu'à la température ambiante.

Les lingots ainsi obtenus ont été caractérisés.

L'examen des photographies en figures 2.a et 2.b montrent que dans le cas du creuset non siliciuré, le lingot est recouvert d'une croûte de SiC sur l'ensemble de ses faces. En revanche dans le cas du creuset siliciuré obtenu selon l'invention, les parois du lingot sont brillantes et exemptes de film de SiC.

Le profil de teneur en carbone dissous le long de la hauteur de chaque lingot a été également déterminé par spectrométrie infra-rouge à transformée de Fourier.

Les résultats sont présentés en figures 2.c et 2.d.

Les analyses de carbone dissous montrent des teneurs en bas de lingot, bien inférieures à la limite de solubilité de C dans Si, la ségrégation de C suivant ensuite une loi de Scheil (contrairement au cas du creuset non siliciuré où le Si est saturé en C et contient des précipités de SiC). La siliciuration du graphite a donc permis d'éviter la carburation totale du lingot de silicium et de baisser la concentration en carbone dissous dans le silicium.

Il a également été procédé à une cartographie de durée de vie des porteurs de charge. Les résultats sont présentés en figures 2.e et 2.f.

Les mesures de durée de vie des porteurs de charge, caractéristiques de la qualité électrique du silicium, ont été réalisées sur des tranches verticales au centre des deux lingots. D'après les cartographies, la durée de vie maximale au cœur du lingot est bien plus élevée pour le lingot élaboré dans le creuset siliciuré (7 |is contre 3 µs).

La siliciuration semble donc également entraîner une réduction de la contamination en impuretés métalliques.

Il a également été déterminé le profil de résistivité visé par le contrôle du dopage de la charge de silicium (pointillés) et le profil de résistivité mesuré dans chaque lingot (traits pleins). Ces résultats sont reportés en figures 2.g et 2.h.

Les profils de résistivité mesurés le long de la hauteur des lingots, y sont reportés par comparaison au profil théorique correspondant au dopage à 0,08 ppm poids de bore.

Il en ressort que la résistivité du lingot élaboré dans le creuset non siliciuré est bien plus faible que la résistivité visée, indiquant une contamination du lingot en éléments dopants présents en tant qu'impuretés dans le graphite.

Par contre, la résistivité du lingot élaboré dans le creuset siliciuré est très proche de la résistivité visée, démontrant l'absence de diffusion (ou une diffusion très réduite) d'impuretés dopantes du creuset vers le silicium grâce à la présence de la couche superficielle de SiC.

L'ensemble de ces observations démontre que la couche de SiC en surface du graphite est une barrière efficace à la diffusion du carbone et des impuretés dopantes (voire métalliques) présentes dans le graphite.

### EXEMPLE 3

### Siliciuration d'une plaque de graphite selon le procédé de l'invention

Une plaque en graphite (2020 de Mersen) de forme complexe, de dimensions 36x26x2 cm³ présentant des trous et des cavités a été siliciurée sur la totalité de sa surface.

La nature de poudre de silicium et les conditions de sa mise en œuvre décrites en exemple 1, ont été reproduites à l'identique dans cet exemple 3.

La siliciuration a été effectuée en deux temps :
- sur la première face (cavités et trous inclus) et sur la tranche,
- sur la deuxième face (trous inclus) et sur la tranche à nouveau.

Chaque traitement de siliciuration a été effectué en déposant une quantité de silicium de 47 mg/cm² (au niveau des trous et des cavités, une masse plus importante a été déposée).

Pour chaque siliciuration, le cycle thermique a été réalisé dans un four sous vide (pression résiduelle de l'ordre de 0,1 Pa) et a consisté en :
- une montée en température à 300°C/h jusqu'à 1450°C
- un palier de 10h à 1450°C
- un refroidissement à 300°C/h.

La pièce siliciurée a ensuite été découpée et des prélèvements ont été préparés pour une observation de la couche de SiC en coupe transversale.

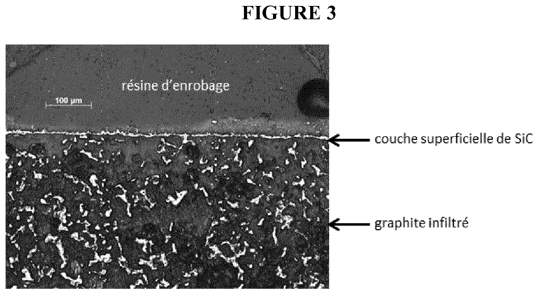

Les observations des prélèvements montrent que la couche de SiC est continue (Fig. 3), y compris dans les zones (trous et cavités).

## Revendications

1. Procédé utile pour la siliciuration surfacique d'un matériau carboné comprenant au moins les étapes consistant à :
a) Mettre en contact ladite surface à traiter avec une quantité efficace de particules de silicium de taille granulométrique variant de 0,2 à 500 µm, de pureté entre 2N et 5N, et dont la teneur en oxygène est inférieure à 10 % en poids.
b) Imposer, au moins à ladite surface revêtue desdites particules de silicium, un traitement thermique propice à la fusion du silicium et à son interaction à l'état fondu avec le carbone de ladite surface pour former du SiC en quantité suffisante pour former, en surface, une couche superficielle de SiC imperméable et en contact direct avec le carbone de ladite surface externe et combler, si existantes, les porosités de ladite surface, et
c) Éliminer le silicium libre en excès par évaporation sous vide,
les étapes b) et c) étant réalisées au moyen d'un traitement thermique comprenant au moins un cycle de 3 étapes successives correspondant à une montée en température, notamment à une vitesse comprise entre 300 et 600°C/h, jusqu'à une température propice à la fusion dudit silicium, notamment supérieure à 1415°C, le maintien d'un palier de température, notamment d'au moins 20 minutes, à ladite température propice à la fusion du silicium et un refroidissement en température notamment à une vitesse comprise entre 100 et 600°C/h, ledit matériau carboné étant un substrat en graphite possédant, au moins au niveau de la surface à siliciurer, une porosité volumique inférieure à 25 % et un diamètre de pores inférieur à 2 µm,
avec ladite couche superficielle de SiC obtenue étant constituée à plus de 99 % en poids de SiC et étant dite imperméable car sa perte de poids est inférieure à 10⁻² g/cm² de surface recouverte après un traitement thermique de 2 heures à 900°C sous air.

2. Procédé selon la revendication précédente comprenant en outre une étape dédiée à la formation, en surface de la couche continue et adhérente de carbure de silicium obtenue, d'un revêtement anti-adhérent poreux de nitrure de silicium.

3. Procédé selon l'une quelconque des revendications précédentes dans lequel le traitement thermique comprend un unique cycle réalisé intégralement sous vide et avantageusement à une pression inférieure à 0,1 Pa.

4. Procédé selon l'une quelconque des revendications 1 à 2 dans lequel le traitement thermique comprend un cycle unique dont au moins l'étape d'évaporation du silicium en excès est faite sous vide, et l'étape de formation de la couche continue de SiC est faite sous atmosphère neutre, en particulier non azotée.

5. Procédé selon l'une quelconque des revendications 1 à 2 dans lequel le traitement thermique comprend un cycle réalisé sous atmosphère neutre, en particulier non azotée, et un cycle réalisé sous vide.

6. Procédé selon l'une quelconque des revendications précédentes dans lequel la température propice à la fusion dudit silicium est supérieure à 1415°C et notamment varie de 1430 à 1500°C.

7. Procédé selon l'une quelconque des revendications précédentes dans lequel le palier de maintien à une température propice à la fusion du silicium dure au moins 20 minutes et de préférence de 6 à 15 heures.

8. Procédé selon l'une quelconque des revendications précédentes dans lequel l'étape d'élimination de l'excès de silicium est réalisée par reproduction d'un cycle thermique sous vide.

9. Procédé selon l'une quelconque des revendications précédentes dans lequel la surface à siliciurer possède une porosité volumique inférieure à 20 %.

10. Procédé selon l'une quelconque des revendications précédentes dans lequel la quantité de silicium considérée correspond à la quantité de silicium nécessaire au comblement, sous la forme de SiC, des pores de la surface à siliciurer, majorée d'un excès de silicium, de l'ordre de 10 à 20 mg/cm².

11. Procédé selon l'une quelconque des revendications précédentes dans lequel les particules de silicium possèdent un diamètre moyen (en volume) variant de 0,2 à 500 µm, de préférence de 1 à 50 µm et de préférence est une poudre de silicium de recyclage issue de la découpe des lingots de silicium à la scie à fil diamant, présentant une pureté comprise entre 2N et 4N et une teneur en oxygène inférieure à 10 % en poids.

12. Procédé selon l'une quelconque des revendications précédentes dans lequel les particules de silicium sont mises en œuvre en étape a) sous la forme d'une dispersion dans un milieu solvant, notamment aqueux.

13. Procédé selon l'une quelconque des revendications précédentes dans lequel la mise en contact de la surface à siliciurer avec une quantité efficace de particules de silicium est réalisée en présence d'un liant polymérique réticulable et en particulier un alcool polyvinylique (PVA) et de préférence mis en œuvre dans un rapport massique [Si: PVA] variant de [1 Si : 0,2 PVA] à [1 Si: 0,02 PVA], et de préférence de [1 Si: 0,15 PVA] à [1 Si: 0,04 PVA].

14. Procédé selon l'une quelconque des revendications précédentes comprenant préalablement à l'étape de traitement thermique au moins les étapes consistant à :
- disposer d'une dispersion en milieu solvant d'au moins lesdites particules de silicium et comprenant en outre un liant polymérique réticulable et,
- mettre en contact ladite dispersion avec la surface à traiter dudit substrat en graphite, ladite surface étant chauffée à une température propice à l'initiation de la réticulation dudit liant, de préférence à une température variant de 150°C à 300°C.

15. Procédé selon l'une quelconque des revendications précédentes dans lequel la couche superficielle de SiC formée possède une épaisseur moyenne variant de 2 à 15 µm.

16. Procédé selon l'une quelconque des revendications précédentes dans lequel la couche superficielle de SiC est constituée à plus de 99,9 % de préférence à plus de 99,99 % en poids de SiC.

17. Procédé selon l'une quelconque des revendications 1 à 16 dans lequel le substrat carboné est du graphite et la couche superficielle de SiC possède une interface, avec le graphite constituant le substrat, qui est formée du SiC comblant les pores et de graphite constitutif du substrat, la fraction volumique de SiC étant inférieure à celle du graphite dans cette interface.

18. Procédé selon l'une quelconque des revendications 1 à 17 dans lequel le matériau carboné est un creuset en graphite dédié à la solidification et la surface traitée est celle de sa cavité interne.

## Patentansprüche

1. Verfahren zur oberflächlichen Silicidierung eines kohlenstoffhaltigen Materials, wobei es zumindest die folgenden Schritte umfasst:
a) Inkontaktbringen der zu behandelnden Oberfläche mit einer wirksamen Menge an Siliciumpartikeln, deren Korngröße im Bereich von 0,2 bis 500 µm liegt, deren Reinheitsgrad zwischen 2N und 5N beträgt und deren Sauerstoffgehalt weniger als 10 Gewichts-% beträgt,
b) Einwirkenlassen, zumindest auf die Oberfläche, welche mit den Siliciumpartikeln beschichtet ist, einer Wärmebehandlung, die dazu geeignet ist zu bewirken, dass das Silicium schmilzt und im geschmolzenen Zustand mit dem Kohlenstoff der Oberfläche in Wechselwirkung tritt, um SiC in einer Menge zu bilden, die ausreicht, um an der Oberfläche eine oberflächliche SiC-Schicht zu bilden, die undurchlässig ist und unmittelbar mit dem Kohlenstoff der äußeren Oberfläche in Kontakt ist, wobei sie gegebenenfalls die Poren dieser Oberfläche ausfüllt, und
c) Entfernen des überschüssigen freien Siliciums durch Vakuumverdampfung,
wobei die Schritte b) und c) mittels einer Wärmebehandlung durchgeführt werden, die zumindest einen Zyklus aus 3 aufeinanderfolgenden Schritten umfasst, welche einem Temperaturanstieg, insbesondere mit einer Geschwindigkeit im Bereich von 300 bis 600 °C/Std., bis auf einen Temperatur, die dazu geeignet ist, das Silicium zum Schmelzen zu bringen, wobei sie insbesondere mehr als 1415 °C beträgt, dem Halten einer Temperaturstufe, insbesondere mindestens 20 Minuten lang, bei der Temperatur, die dazu geeignet ist, das Silicium zum Schmelzen zu bringen, und einer Temperaturabkühlung entsprechen, welche insbesondere mit einer Geschwindigkeit im Bereich von 100 bis 600 °C/Std. erfolgt, wobei es sich bei dem kohlenstoffhaltigen Material um ein Substrat aus Graphit handelt, das zumindest im Bereich der zu silicidierenden Oberfläche eine volumenbezogene Porosität von weniger als 25 % und einen Porendurchmesser von weniger als 2 µm besitzt, wobei die erhaltene oberflächliche SiC-Schicht zu mehr als 99 Gewichts-% aus SiC besteht und als undurchlässig bezeichnet wird, da ihr Gewichtsverlust infolge einer 2-stündigen Wärmebehandlung bei 900 °C unter Luftzufuhr weniger als 10⁻² g/cm² an bedeckter Oberfläce beträgt.

2. Verfahren nach dem vorhergehenden Anspruch, wobei es darüber hinaus einen Schritt umfasst, der dazu dient, an der Oberfläche der erhaltenen durchgehenden und anhaftenden Siliciumcarbidschicht eine poröse Antihaft-Beschichtung aus Siliciumnitrid zu bilden.

3. Verfahren nach einem beliebigen der vorhergehenden Ansprüche, wobei die Wärmebehandlung einen einzigen Zyklus umfasst, welcher vollständig unter Vakuum und vorteilhafterweise bei einem Druck von weniger als 0,1 Pa durchgeführt wird.

4. Verfahren nach einem beliebigen der Ansprüche 1 bis 2, wobei die Wärmebehandlung einen einzigen Zyklus umfasst, wobei zumindest dessen Schritt des Verdampfens des überschüssigen Siliciums unter Vakuum erfolgt, und der Schritt des Bildens der durchgehenden Schicht aus SiC unter einer neutralen, insbesondere stickstofffreien, Atmosphäre erfolgt.

5. Verfahren nach einem beliebigen der Ansprüche 1 bis 2, wobei die Wärmebehandlung einen Zyklus, welcher unter neutraler, insbesondere stickstofffreier Atmosphäre durchgeführt wird, und einen Zyklus umfasst, welcher unter Vakuum durchgeführt wird.

6. Verfahren nach einem beliebigen der vorhergehenden Ansprüche, wobei die Temperatur, welche dafür geeignet ist, das Silicium zum Schmelzen zu bringen, mehr als 1415 °C beträgt und insbesondere im Bereich von 1430 bis 1500 °C liegt.

7. Verfahren nach einem beliebigen der vorhergehenden Ansprüche, wobei die Stufe des Haltens bei einer Temperatur, die dazu geeignet ist, das Silicium zum Schmelzen zu bringen, mindestens 20 Minuten und vorzugsweise 6 bis 15 Stunden lang dauert.

8. Verfahren nach einem beliebigen der vorhergehenden Ansprüche, wobei der Schritt des Beseitigens des Siliciumüberschusses durchgeführt wird, indem ein erneuter Wärmezyklus unter Vakuum erfolgt.

9. Verfahren nach einem beliebigen der vorhergehenden Ansprüche, wobei die zu silicidierende Oberfläche eine volumenbezogene Porosität von weniger als 20 % besitzt.

10. Verfahren nach einem beliebigen der vorhergehenden Ansprüche, wobei die in Betracht gezogene Menge an Silicium der Menge an Silicium entspricht, welche dazu erforderlich ist, die Poren der zu silicidierenden Oberfläche in Form von SiC auszufüllen, zuzüglich eines Überschusses an Silicium in der Größenordnung von 10 bis 20 mg/cm².

11. Verfahren nach einem beliebigen der vorhergehenden Ansprüche, wobei die Siliciumpartikel einen (volumenbezogenen) mittleren Durchmesser besitzen, der im Bereich von 0,2 bis 500 µm, vorzugsweise von 1 bis 50 µm, liegt, und sie sich dabei vorzugsweise um ein Siliciumpulver handeln, welches ausgehend von Zuschnitt von Siliciumbarren mit einer Diamantdrahtsäge wiedergewonnen wurde, wobei es einen Reinheitsgrad im Bereich von 2N bis 4N und einen Sauerstoffgehalt von weniger als 10 Gewichts-% aufweist.

12. Verfahren nach einem beliebigen der vorhergehenden Ansprüche, wobei die Siliciumpartikel im Schritt a) in Form einer Dispersion in einem Lösungsmittelmedium, insbesondere wässriger Art, eingesetzt werden.

13. Verfahren nach einem beliebigen der vorhergehenden Ansprüche, wobei das Inkontaktbringen der zu silicidierenden Oberfläche mit einer wirksamen Menge an Siliciumpartikeln in Gegenwart eines vernetzbaren polymerartigen Bindemittels und insbesondere eines Polyvinylalkohols (PVA) erfolgt, wobei dieses vorzugsweise in einem [Si : PVA]-Massenverhältnis eingesetzt wird, das im Bereich von [1 Si : 0,2 PVA] bis [1 Si : 0,02 PVA] und vorzugsweise von [1 Si : 0,15 PVA] bis [1 Si : 0,04 PVA] liegt.

14. Verfahren nach einem beliebigen der vorhergehenden Ansprüche, wobei es im Vorfeld des Wärmebehandlungsschrittes zumindest die folgenden Schritte umfasst:
- Bereitstellen einer Dispersion zumindest der Siliciumpartikel in einem Lösungsmittelmedium, wobei sie darüber hinaus ein vernetzbares polymerartiges Bindemittel umfasst, und
- Inkontaktbringen der Dispersion mit der zu behandelnden Oberfläche des Substrats aus Graphit, wobei die Oberfläche auf eine Temperatur erhitzt ist, welche dafür geeignet ist, die Vernetzung des Bindemittels einzuleiten, vorzugsweise auf eine Temperatur im Bereich von 150 °C bis 300 °C.

15. Verfahren nach einem beliebigen der vorhergehenden Ansprüche, wobei die oberflächliche Schicht aus SiC nach ihrer Bildung eine mittlere Dicke im Bereich von 2 bis 15 µm besitzt.

16. Verfahren nach einem beliebigen der vorhergehenden Ansprüche, wobei die oberflächliche Schicht aus SiC zu mehr als 99, 9 %, vorzugsweise zu mehr als 99, 99 % nach Gewicht, aus SiC besteht.

17. Verfahren nach einem beliebigen der Ansprüche 1 bis 16, wobei es sich bei dem kohlenstoffhaltigen Substrat um Graphit handelt und die oberflächliche Schicht aus SiC eine Grenzfläche mit dem Graphit besitzt, welcher das Substrat bildet, wobei diese aus dem SiC, welches die Poren ausfüllt, und aus dem Graphit gebildet ist, aus welchem das Substrat besteht, wobei in dieser Grenzfläche der Volumenanteil an SiC geringer als derjenige des Graphits ist.

18. Verfahren nach einem beliebigen der Ansprüche 1 bis 17, wobei es sich bei dem kohlenstoffhaltigen Material um einen Tiegel aus Graphit handelt, welcher dem Erstarrenlassen dient, und es sich bei der behandelten Oberfläche um diejenige des inneren Hohlraums desselben handelt.

## Claims

1. Process of use for the surface silicidation of a carbon-based material comprising at least the steps consisting in:
a) bringing said surface to be treated into contact with an effective amount of silicon particles with a particle size varying from 0.2 to 500 µm, with a purity between 2N and 5N, and with an oxygen content of less than 10% by weight,
b) imposing, at least at said surface coated with said silicon particles, a heat treatment favourable to the melting of the silicon and to its interaction in the molten state with the carbon of said surface to form SiC in an amount sufficient to form, at the surface, an impermeable surface SiC layer in direct contact with the carbon of said external surface and to fill in, if existing, the porosities of said surface, and
c) removing the excess free silicon by vacuum evaporation,
steps b) and c) being carried out by means of a heat treatment comprising at least one cycle of 3 successive steps corresponding to a rise in temperature, in particular at a rate of between 300 and 600°C/h, up to a temperature favourable to the melting of said silicon, in particular of greater than 1415°C, the maintenance of a temperature stationary phase, in particular of at least 20 minutes, at said temperature favourable to the melting of the silicon and a cooling in temperature, in particular at a rate of between 100 and 600°C/h, said carbon-based material being a graphite substrate having, at least at the surface to be silicidized, a porosity by volume of less than 25% and a pore diameter of less than 2 µm,
with said surface SiC layer obtained consisting, to more than 99% by weight, of SiC and being "impermeable" because its loss in weight is less than 10⁻² g/cm² of covered surface after a heat treatment at 900°C under air for 2 hours.

2. Process according to the preceding claim, additionally comprising a step dedicated to the formation, at the surface of the continuous and adherent layer of silicon carbide obtained, of a porous nonstick coating of silicon nitride.

3. Process according to either one of the preceding claims, in which the heat treatment comprises a single cycle carried out entirely under vacuum and advantageously at a pressure of less than 0.1 Pa.

4. Process according to either one of Claims 1 and 2, in which the heat treatment comprises a single cycle, at least the step of evaporation of the excess silicon of which is carried out under vacuum and the step of formation of the continuous SiC layer of which is carried out under a neutral atmosphere, in particular a non-nitrogenous atmosphere.

5. Process according to either one of Claims 1 and 2, in which the heat treatment comprises a cycle carried out under a neutral atmosphere, in particular a non-nitrogenous atmosphere, and a cycle carried out under vacuum.

6. Process according to any one of the preceding claims, in which the temperature favourable to the melting of said silicon is greater than 1415°C and in particular varies from 1430 to 1500°C.

7. Process according to any one of the preceding claims, in which the stationary phase of maintenance at a temperature favourable to the melting of the silicon lasts at least 20 minutes and preferably from 6 to 15 hours.

8. Process according to any one of the preceding claims, in which the step of removal of the silicon excess is carried out by reproduction of a thermal cycle under vacuum.

9. Process according to any one of the preceding claims, in which the surface to be silicidized has a porosity by volume of less than 20%.

10. Process according to any one of the preceding claims, in which the amount of silicon under consideration corresponds to the amount of silicon necessary to fill in, in the form of SiC, the pores of the surface to be silicidized, increased by a silicon excess, of the order of 10 to 20 mg/cm².

11. Process according to any one of the preceding claims, in which the silicon particles have a (volume-) average diameter varying from 0.2 to 500 µm, preferably from 1 to 50 µm, and are preferably a recycling silicon powder resulting from a cutting of silicon ingots with a diamond wire saw, exhibiting a purity of between 2N and 4N and an oxygen content of less than 10% by weight.

12. Process according to any one of the preceding claims, in which the silicon particles are employed in step a) in the form of a dispersion in a solvent medium, in particular an aqueous medium.

13. Process according to any one of the preceding claims, in which the contacting of the surface to be silicidized with an effective amount of silicon particles is carried out in the presence of a crosslinkable polymeric binder and in particular a polyvinyl alcohol (PVA), preferably employed in an [Si:PVA] ratio by weight varying from [1 Si:0.2 PVA] to [1 Si:0.02 PVA] and preferably from [1 Si:0.15 PVA] to [1 Si:0.04 PVA].

14. Process according to any one of the preceding claims, comprising, prior to the heat treatment step, at least the steps consisting in:
- providing a dispersion, in a solvent medium, of at least said silicon particles additionally comprising a crosslinkable polymeric binder and
- bringing said dispersion into contact with the surface to be treated of said graphite substrate, said surface being heated to a temperature favourable to the initiation of the crosslinking of said binder, preferably to a temperature varying from 150°C to 300°C.

15. Process according to any one of the preceding claims, in which the surface SiC layer formed has a mean thickness varying from 2 to 15 µm.

16. Process according to any one of the preceding claims, in which the surface SiC layer consists, to more than 99.9%, preferably to more than 99.99%, by weight of SiC.

17. Process according to any one of Claims 1 to 16, in which the carbon-based substrate is graphite and the surface SiC layer has an interface, with the graphite constituting the substrate, which is formed of the SiC filling in the pores and of constituent graphite of the substrate, the fraction by volume of SiC being less than that of the graphite in this interface.

18. Process according to any one of Clams 1 to 17, in which the carbon-based material is a graphite crucible dedicated to the solidification and the treated surface is that of its internal cavity.
